Europäisches Patentamt

European Patent Office

Office européen des brevets

(19)

(11) **EP 1 165 855 B1**

(12) **FASCICULE DE BREVET EUROPEEN**

(45) Date de publication et mention
de la délivrance du brevet:
**10.12.2003 Bulletin 2003/50**

(21) Numéro de dépôt: **00910915.8**

(22) Date de dépôt: **09.03.2000**

(51) Int Cl.$^7$: **C23C 16/02**, C23C 16/50

(86) Numéro de dépôt international:
**PCT/FR00/00585**

(87) Numéro de publication internationale:
**WO 00/053823 (14.09.2000 Gazette 2000/37)**

(54) **PROCEDE DE TRAITEMENT DE SURFACE DES POLYMERES**

VERFAHREN ZUR OBERFLÄCHENBEHANDLUNG VON POLYMEREN

METHOD FOR TREATING POLYMER SURFACE

(84) Etats contractants désignés:
**CH DE FR GB IT LI**

(30) Priorité: **09.03.1999 FR 9902923**

(43) Date de publication de la demande:
**02.01.2002 Bulletin 2002/01**

(73) Titulaire: **Centre National de la Recherche
Scientifique
75794 Paris Cedex 16 (FR)**

(72) Inventeurs:
• **DREVILLON, Bernard
F-92140 Clamart (FR)**
• **BULKINE, Pavel, Résidence d'Orsay
F-91400 Orsay (FR)**
• **HOFRICHTER, Alfred, Franz
F-75014 Paris (FR)**

(74) Mandataire: **Michelet, Alain et al
Cabinet Harlé et Phélip
7, rue de Madrid
75008 Paris (FR)**

(56) Documents cités:
**EP-A- 0 570 944          WO-A-88/08043
WO-A-99/05546**

• **TAKAHASHI S ET AL: "IMPROVEMENT OF
ADHESION TO SIN THIN FILM ON THE
POLYCARBONATE SUBSTRATE"
ELECTRONICS & COMMUNICATIONS IN JAPAN,
PART II - ELECTRONICS,US,SCRIPTA
TECHNICA. NEW YORK, vol. 74, no. 5, page 60-70
XP000270202 ISSN: 8756-663X**
• **PATENT ABSTRACTS OF JAPAN vol. 1995, no.
03, 28 avril 1995 (1995-04-28) & JP 06 344495 A
(SEKISUI CHEM CO LTD), 20 décembre 1994
(1994-12-20) -& DATABASE WPI Section Ch,
Week 9510 Derwent Publications Ltd., London,
GB; Class A11, AN 1995-069810 XP002123105
"gas barrier film useful for packaging e.g
chemicals..." & JP 06 344495 A (SEKISUI CHEM
IND CO LTD) , 20 décembre 1994 (1994-12-20)**
• **BULKIN P ET AL: "Plasma enhanced chemical
vapour deposition of silica thin films in an
integrated distributed electron cyclotron
resonance reactor" THIN SOLID
FILMS,CH,ELSEVIER-SEQUOIA S.A.
LAUSANNE, vol. 308-309, no. 1-4, page 63-67
XP004110245 ISSN: 0040-6090 cité dans la
demande**
• **LEE J H ET AL: "MECHANICAL PROPERTIES OF
A-C:H AND A-C:H/SIOX NANOCOMPOSITE THIN
FILMS PREPARED BY ION-ASSISTED
PLASMA-ENHANCED CHEMICAL VAPOR
DEPOSITION" THIN SOLID
FILMS,CH,ELSEVIER-SEQUOIA S.A.
LAUSANNE, vol. 280, no. 1/02, page 204-210
XP000637289 ISSN: 0040-6090**

**Description**

La présente invention concerne un procédé de traitement de surface pour protection et fonctionnalisation des polymères (matières plastiques synthétiques organiques). Elle permet de rendre la surface d'une matière plastique moins sensible à l'environnement, de constituer une barrière physique et/ou chimique de protection, de réaliser des composants électroniques ou optoélectroniques sur substrat polymère... Elle permet plus particulièrement la réalisation d'une protection anti-rayure, de fonctionnalités de filtrage optique, de barrières (à la vapeur d'eau ou l'oxygène par exemple). Elle permet également d'élaborer des écrans d'affichages. Elle est utilisable, mais pas exclusivement, dans le domaine du vitrage lorsque l'on utilise des matériaux organiques en remplacement du verre, en particulier dans l'automobile. Un produit polymère obtenu selon le procédé est aussi revendiqué.

On connaît des procédés par lesquels la surface d'un matériau, verre ou métal, est protégé par le dépôt d'une ou plusieurs couches d'alliages de silicium, silice par exemple. On constate que le dépôt de silice est d'autant plus adhérent, homogène et non poreux que la température du substrat est élevée lors du dépôt.

En plus de l'effet protecteur de la silice, des effets optiques peuvent être obtenus par empilement de couches d'alliages de silicium d'indices de réfraction différents. Ces effets optiques sont en particulier des effets de filtrage optique.

Ces matériaux minéraux sont relativement lourds et ne se prêtent pas facilement à la réalisation de formes complexes ou pliables ou souples. On souhaite donc, de plus en plus souvent, les remplacer par des polymères présentant des propriétés optiques équivalentes mais qui soient plus légers et plus simples à mettre en oeuvre. Cependant, les polymères connus présentent généralement des caractéristiques de résistance en surface encore plus réduites vis-à-vis des agressions chimiques et/ou physiques environnementales. En particulier, ces sont facilement rayables. Il a donc été proposé de protéger la surface de ces matériaux par la réalisation ou l'application d'une couche protectrice. A cette fin, une (ou plusieurs) couche protectrice d'une épaisseur de quelques micromètres doit être déposée. Cette couche doit adhérer de manière durable. On constate que pour une couche épaisse nécessaire pour une bonne protection anti-rayure, l'adhésion est un paramètre critique.

L'invention concerne donc un procédé de traitement de surfaces pour protection et fonctionnalisation des polymères, par dépôt par plasma gazeux dans une enceinte confinée d'au moins une couche d'un alliage de silicium.

Selon l'invention,

- l'alliage de silicium est choisi parmi le silicium, les oxydes de silicium, les nitrures de silicium, les oxynitrures de silicium;
- un pré-traitement de surface par plasma est effectué dans la même enceinte avant dépôt de l'alliage de silicium, le pré-traitement consistant en un traitement de la surface comprenant la gravure (ou ablation) d'une zone superficielle du polymère et en une étape de dépôt d'un composé de carbone polymérique

Le terme alliage signifie une combinaison entre le silicium et un ou plusieurs autres atomes mais il doit aussi être considéré ici comme signifiant le silicium seul. Les oxydes de silicium peuvent être du type SiOx dont la silice (x = 2) ou des oxydes de silicium non stoechiométriques (x ≠ 2). Le dépôt est effectué à une température inférieure à la température de dégradation du polymère. La température de dégradation du polymère correspond à une température à laquelle la matière se ramollit ou entre en fusion voire en combustion et plus généralement à une température à laquelle la matière perd ses propriétés d'utilisation. Il n'est donc généralement pas nécessaire de chauffer spécifiquement la matière dans ce procédé. Si toutefois un chauffage est nécessaire, celui-ci peut être fait à une température inférieure à la température de dégradation de la matière.

On entend par carbone polymérique un carbone amorphe fortement hydrogéné (d'au moins 10 % d'hydrogène en pourcentage atomique), à indice optique faible et de bande interdite élevée (3 à 5 eV). Par exemple, le matériau cité dans le tableau 1 (a-C:H 1) a un indice de 1.59 (2 eV), une concentration d'hydrogène de 56 % et une densité de 1.2 $g/cm^3$.

Dans divers modes de mise en oeuvre de l'invention, les moyens suivants pouvant éventuellement être combinés selon toutes les possibilités techniquement réalisables, sont mis en oeuvre :

- on effectue d'abord le traitement de la surface puis, ensuite le dépôt du composé de carbone polymérique ;
- l'étape de dépôt du composé de carbone polymérique est commencée avant la fin du traitement de surface ;
- la préparation est obtenue par l'action d'un plasma généré à partir d'un gaz oxydant. Le gaz oxydant peut, par exemple, être choisi parmi l'oxygène et le $N_2O$ ;
- l'épaisseur gravée de la zone superficielle est comprise entre 20 angströms et 3000 angströms ;
- l'épaisseur gravée de la zone superficielle est comprise entre 100 angströms et 900 angströms et est préférentiellement approximativement de 500 angströms ;
- le dépôt du composé de carbone est obtenu par l'action d'un plasma généré à partir d'un gaz carboné, les gaz carbonés étant choisis parmi le méthane, éthane, butane, propane, pentane, hexane et leurs dérivés mono ou poly insaturés dont l'éthylène, l'acétylène ;

- l'épaisseur du dépôt de composé de carbone est comprise entre 30 angstrôms et 130 angströms et préférentiellement entre 50 angstrôms et 100 angströms ;
- le composé de carbone déposé est du carbone hydrogéné sous forme amorphe ;
- le polymère est du polycarbonate ;
- le polymère est choisi parmi les polyméthyle méthacrylates, les polyéthylènes, les polypropylènes, les polyéthylène téréphtalates ;
- le polymère brut est traité directement dans l'enceinte ;
- plusieurs couches d'alliages de silicium sont déposées, par exemple pour obtenir un ou plusieurs effets optiques ;
- le réacteur à plasma est choisi parmi les réacteurs à micro-ondes ou radiofréquence dont les réacteurs à résonance cyclotronique électronique, les réacteurs à résonance cyclotronique électronique distribuée, les réacteurs à pulvérisation cathodique. Les réacteurs à pulvérisation cathodique sont encore dits "à cible" ;
- la matière plastique est du polycarbonate, l'épaisseur de la couche de carbone hydrogéné amorphe est comprise entre 50 angströms et 100 angströms et une seule couche de silice d'épaisseur comprise entre 1 et 7 μm et préférentiellement d'environ 5 μm est déposée.

L'invention concerne également un produit polymère ayant subi un traitement de surface pour protection et fonctionnalisation.

Selon l'invention, le polymère traité selon l'un quelconque des modes de réalisation du procédé défini plus haut comporte en surface une zone préparée et une couche de carbone amorphe surmontée d'une ou plusieurs couches d'un ou plusieurs alliages de silicium.

Ce procédé permet l'obtention de couches de protection et de fonctionnalisation sur des surfaces de polymères de formes variées, les couches étant durables et fortement adhérentes par rapport aux procédés connus. Le terme protection correspond à toute protection, isolément ou en combinaison, contre les agressions mécaniques, rayures par exemple, optiques, ultraviolets par exemple, et aussi possiblement chimiques.

Le traitement par plasma permettant de traiter des surfaces importantes et les étapes du procédé de l'invention se déroulant toutes dans la même enceinte sans rupture du vide et sans qu'un chauffage de la matière soit requis, des rendements importants peuvent être obtenus. Le procédé de dépôt par plasma permet aussi de réaliser des éléments optiques par empilement de couches présentant des indices différents, soit, par sauts d'indices, soit par variations continues d'indice dans une couche, voire une combinaison des deux. La possibilité de réaliser un filtre optique peut, par exemple, permettre de protéger la masse de matière plastique des rayonnements ultraviolets et, ainsi, d'augmenter sa durée de vie.

En plus de l'application au vitrage automobile, d'autres applications sont envisagées pour l'invention, en particulier toutes les applications où le verre peut être remplacé par un polymère, par exemple, les fenêtres optiques de projecteurs de lumière et les composants électroniques de grande surface à base de silicium en couche mince déposé par plasma. Dans toutes ces applications, le polymère ou matière plastique est essentiellement choisi pour ses propriétés de légèreté et de transparence optique en remplacement du verre. Le polymère peut également être choisi pour ses propriétés mécaniques avantageuses par rapport au verre et en particulier l'aptitude au pliage et à la déformation.

Le procédé et la matière plastique traitée selon l'invention peuvent avoir d'autres applications, par exemple la réalisation d'emballages souples en matière plastique ou de boîtiers, par exemple pour les propriétés de barrière de la silice et, en particulier, contre la diffusion de la vapeur d'eau et/ou l'oxygène.

Enfin, la mise en oeuvre du procédé est extrêmement simple et ne nécessite pas la mise en oeuvre d'un réacteur à plasma fondamentalement nouveau. En effet, le procédé permet d'utiliser tout réacteur à plasma gazeux pour dépôt d'alliages de silicium en prévoyant simplement l'arrivée d'un gaz supplémentaire qui est un gaz carboné.

La présente invention sera mieux comprise par la description qui suit d'un exemple de mise en oeuvre du procédé où:

- la figure 1 représente un réacteur à plasma du type IDECR plan (Integrated Distributed Electrons Cyclotron Resonance) ou micro-ondes à résonance cyclotronique électronique distribuée ; et où
- la figure 2 représente les étapes du procédé selon l'invention.

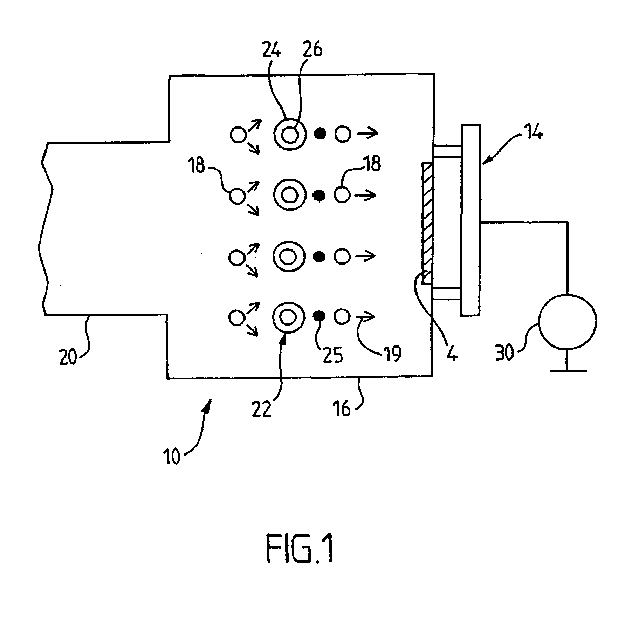

Sur la figure 1, on a représenté un réacteur de traitement, désigné par la référence numérique générale 10. Il est destiné à assurer le traitement de surface d'une pièce en matière plastique 4, constituée par exemple par une plaque en polycarbonate sur un porte-substrat 14.

Comme on le voit sur cette figure 1, l'enceinte 16 comporte un ensemble de buses d'admission d'un mélange gazeux, telles que 18. Le terme mélange gazeux correspond à tout type utile pour la mise en oeuvre de l'invention.

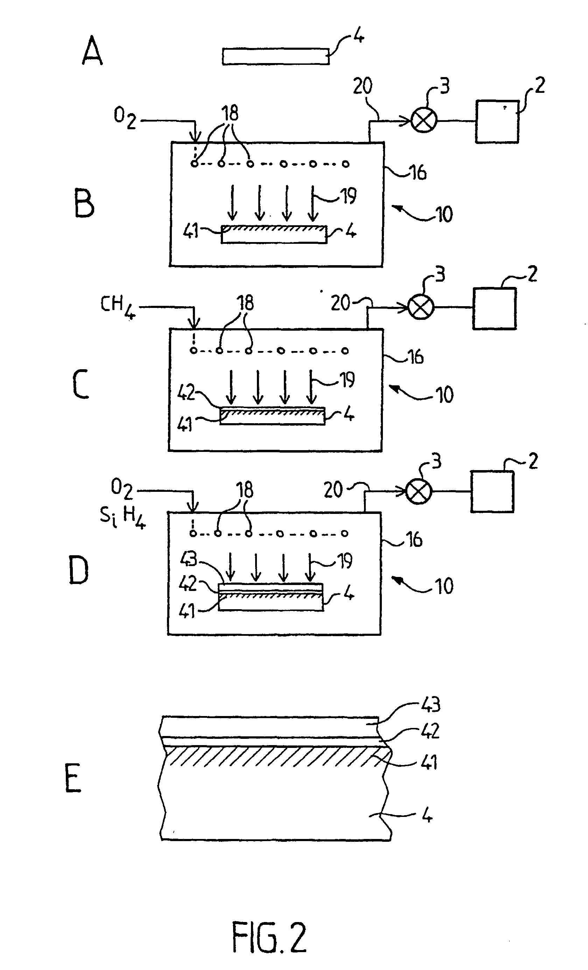

Elle est en outre munie d'une canalisation 20 de raccordement de l'enceinte 16 à une station de pompage (2 sur la figure 2) permettant l'extraction du gaz délivré par les buses 18 et le maintien de la pression de ce gaz à une valeur souhaitée, par exemple entre 1 et 10 mTorr.

L'enceinte 16 est équipée d'un dispositif 22 qui assure l'excitation d'un plasma dans le gaz de traitement, à la résonance cyclotronique électronique. Ce dispositif 22 est constitué par plusieurs applicateurs de champ 24, ayant chacun une forme tubulaire et raccordés par une de leurs extrémités, par tout moyen approprié, tel qu'un câble coaxial, à une source d'énergie dans le domaine des micro-ondes (non représentée), par exemple à une fréquence égale à 2,45 GHz.

Plus particulièrement, les applicateurs 24 sont de préférence des applicateurs connus sous l'appellation " à résonance Cyclotronique Electronique Distribuée " (DECR) ou d'applicateurs élaborés à partir de techniques dérivées classiques.

Par ailleurs, chaque applicateur 24 est équipé de moyens pour créer un champ magnétique statique au voisinage de l'applicateur, à une intensité correspondant à la résonance cyclotronique électronique, c'est-à-dire un champ magnétique statique dont l'intensité B est liée à la fréquence f d'excitation d'un électron placé dans ce champ magnétique statique par la relation suivante :

$$B = \frac{2\pi \times m \times f}{e}$$

dans laquelle m et e sont respectivement la masse et la charge de l'électron. Ainsi, par exemple, pour un rayonnement micro-ondes incident ayant une fréquence de 2,45 GHz, l'intensité du champ magnétique créé au voisinage de chaque applicateur est choisie égale à 875 Gauss.

Dans l'exemple représenté sur la figure 1, les moyens pour créer le champ magnétique statique sont constitués par une antenne entourée d'un aimant 26 de forme longitudinale, disposé à l'intérieur de chaque applicateur 24. Cette construction permet d'obtenir un champ magnétique statique dont la valeur décroît relativement vite et, ainsi, d'obtenir un champ magnétique statique faible, voire nul, dans la zone dans laquelle est disposée la pièce 4 à traiter. En outre, du fait de l'absorption intense du champ micro-onde au voisinage des applicateurs, l'excitation du plasma n'a pas lieu au voisinage immédiat du substrat, limitant ainsi le risque d'altération de ce dernier.

On voit sur la Figure 1 que le réacteur 10 est complété par un ensemble de barreaux métalliques 25, s'étendant transversalement et parallèlement aux applicateurs 24. Ces barreaux 25 sont reliés à la masse, c'est-à-dire à la paroi de l'enceinte 16, pour constituer une référence de masse le long de chaque applicateur afin de structurer le champ micro-onde dans cette zone et faciliter la propagation du rayonnement incident.

Le réacteur 10 est, pour le mode de réalisation représenté, complété par une source de champ électromagnétique 30, par exemple à une fréquence égale à 13,56 MHz, permettant d'assurer une polarisation du porte-substrat, comme cela sera décrit par la suite.

On injecte une puissance micro-ondes au moyen de chaque applicateur 24, au voisinage de chaque buse d'entrée 18 et, simultanément, on crée, dans cette zone, c'est-à-dire dans une zone de l'enceinte 16 distincte de la zone dans laquelle est disposée la pièce 4 à traiter, un champ magnétique statique dont l'intensité correspond, comme cela a été mentionné précédemment, à la résonance cyclotronique électronique. Les lignes de champ magnétique statique créées se bouclent entre deux aimants voisins, on délimite ainsi entre les applicateurs une structure de champ magnétique multipolaire.

On obtient ainsi un plasma hautement dissocié, à basse pression et très actif, permettant le traitement de la pièce 4.

Le porte-substrat 14 est éventuellement soumis à l'influence d'un champ électrique à haute fréquence, ce qui peut permettre d'effectuer une polarisation de ce dernier. En effet, lorsqu'il est soumis à l'influence d'une alternance positive du champ électrique délivré par la source 30, les électrons sont attirés vers la pièce 4, tandis que lorsqu'il est soumis à l'influence d'une alternance négative, les ions positifs sont attirés vers la pièce 4.

On conçoit que les électrons étant plus mobiles que les ions, on obtient une polarisation du porte-substrat, laquelle polarisation est réglable sous le contrôle de la source 30. Il est ainsi possible de contrôler l'énergie des ions venant vers la surface de la pièce 4 à traiter.

Les réacteurs à plasma du type IDECR permettent le dépôt à froid de couches denses à base de silicium. Le terme froid signifiant qu'il n'est généralement pas nécessaire de chauffer spécifiquement la matière ou si un chauffage est effectué, à une température inférieure à la température de dégradation de la matière.

Bien que la figure 1 représente un type particulier de réacteur à plasma, d'autres types de réacteurs à plasma sont utilisables et, par exemple, les réacteurs à pulvérisation cathodique encore dits réacteurs à plasma "à cible", où la matière devant être déposée est arrachée d'une cible disposée dans l'enceinte. Les réacteurs peuvent être du type micro-ondes 2,45 GHz ou radiofréquence 13,56 MHz. Des générateurs de plasma pouvant être utilisés dans la présente invention sont décrits dans "Handbook of plasma processing technology, fundamentals, etching, déposition and surface interaction", S.Rossnagel, J.Cuomo, W.Westwood, Noyes publication, Parkridge 89. Les générateurs du type IDECR sont plus particulièrement décrits dans un article de P.Bulkin dans 'Thin Solid Films" N°308, 309, 1997, page 63.

Sur la Figure 2, les étapes du procédé sont représentées par les références A à D.

En A, un polymère, matière plastique 4, brut est mis en oeuvre. Le terme brut signifie que la matière peut être traitée directement et qu'aucun prétraitement autre que celui de l'invention ou qu'un éventuel nettoyage de la surface à traiter pour éliminer les matières étrangères, salissures ou poussières par exemple, n'est nécessaire. Ce nettoyage éventuel, si la matière est souillée, correspond par exemple à un dégraissage chimique. L'invention s'applique également à de la matière plastique pré-traitée à l'aide d'un nettoyage chimique classique du type dégraissage. Dans cet exemple, la matière plastique est du polycarbonate.

En B, la matière plastique 4 est disposée dans l'enceinte 16 du réacteur 10 à plasma 19, dans lequel un vide d'environ 5 mTorr est réalisé par la conduite 20 reliée à une pompe à vide 2 par l'intermédiaire d'une vanne 3 et/ou d'un régulateur. Un gaz oxydant, de l'oxygène sous forme gazeuse dans ce mode de mise en oeuvre, est envoyé dans l'enceinte 16 par les orifices 18. Les organes générateurs de plasma, non représentés sur cette figure, permettent la création d'un plasma 19 et la préparation de la surface de la matière 4 sur une certaine épaisseur. Cette préparation de la surface, peut correspondre à plusieurs actions physico-chimiques:

- le nettoyage par désorption des résidus de surface (hydrocarbures par exemple),
- l'ablation, le terme gravure étant équivalent, d'une zone superficielle du polymère,
- l'activation de la zone 41 de surface du polymère, ladite activation pouvant comprendre une réticulation du polymère, une dégradation du polymère, un greffage d'oxygène ou de groupements oxygénés en surface,
- une action mécanique d'abrasion de la surface,
- une combinaison de ces actions, voire d'autres causes non encore précisées. La durée de cette préparation sera choisie pour correspondre à une épaisseur de zone gravée d'environ 500 angströms.

En C, le composé de carbone est déposé sur la matière plastique activée. Le carbone dans cet exemple de mise en oeuvre est généré par le plasma à partir d'un gaz qui est du méthane et qui est injecté dans l'enceinte 16 par les orifices 18. Le carbone déposé est alors sous forme de carbone hydrogéné amorphe. Dans ce dernier cas, il convient de s'assurer que la couche de carbone déposée contient suffisamment d'hydrogène. Cependant, toute autre source gazeuse de carbone est utilisable ainsi que le carbone provenant de réacteur à pulvérisation cathodique. La durée de cette étape correspond à une épaisseur de la couche de carbone 42 comprise entre 50 angströms et 100 angströms.

En D, la silice est déposée sur la matière plastique prétraitée aux étapes B puis C. Le réacteur 10 à plasma 19 reçoit de l'oxygène et du silane par exemple. Cependant dans le cas de l'utilisation d'un réacteur à plasma à pulvérisation cathodique, le silicium sera obtenu à partir d'une cible de cette matière disposée dans la même enceinte. Dans cet exemple, une seule couche 43 de silice d'environ 5 $\mu$m d'épaisseur est déposée.

En E, la matière plastique est extraite de l'enceinte, le traitement pour protection de la matière plastique étant terminé. Un agrandissement de la surface traitée est représenté en E. La matière plastique 4 comporte en surface une zone activée 41, une couche de carbone hydrogéné amorphe 42 et une couche de silice 43. Le procédé permettant la réalisation d'un dépôt de qualité sans avoir besoin de chauffer spécifiquement le substrat sur lequel le dépôt doit être effectué, la matière plastique ne subit pas de dégradation ou de contrainte particulière pouvant compromettre ses qualités d'utilisation. Le procédé permet donc d'effectuer au moins un dépôt à au moins la température ambiante.

Une autre possibilité de mise en oeuvre consiste à procéder à un passage graduel de la phase de gravure à la phase de dépôt de la couche de silice en passant par le dépôt d'une couche de carbone amorphe hydrogéné. Ainsi en partant initialement d'un plasma pur d'$O_2$, on peut diminuer la vitesse de gravure en augmentant graduellement la pression partielle du gaz carboné (par exemple $CH_4$), jusqu'à arriver à déposer une couche de carbone amorphe hydrogéné. Cette augmentation de la pression partielle du gaz carboné peut être associée à une diminution de la pression partielle d'$O_2$. Après la pression partielle du gaz carboné peut être graduellement réduite et la pression partielle du précurseur du dépôt de l'alliage de silicium (par exemple $SiH_4$) peut être graduellement augmentée, jusqu'à arriver aux conditions de dépôt de la couche d'alliage de silicium (par exemple silice).

Des essais comparatifs on été effectués. Ces essais ont été effectués à partir des tests normalisés suivants:

- Détermination de la résistance à l'usure par galets abrasifs - (Taber wear test) (DIN 52347). Ce test consiste à déplacer un galet normé (CS F10) avec une force normale fixé (500g) pendant un nombre fixé de cycles (500 ou 1000) sur l'échantillon et de mesurer le " changement du trouble " (Delta Haze), donc d'évaluer le flou en mesurant la quantité de lumière transmise et diffusée.
- Essai de quadrillage (DIN EN ISO 2409). Ce test consiste à couper un quadrillage 10x10 de 1 mm$^2$, d'appliquer un ruban adhésif normé, et de l'arracher. Le nombre de carré de la couche qui reste collé sur le substrat, est une mesure fonctionnelle de l'adhésion de la couche.

- Cycles thermiques. Ce test consiste à faire subir à l'échantillon 10 cycles de -40° à +90°C pendant cinq jours.

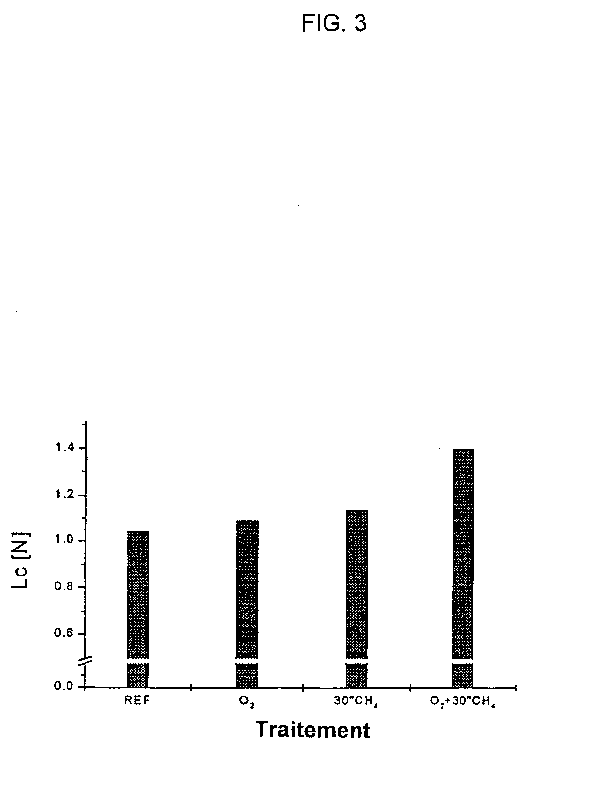

On a également réalisé des tests de rayures dont les résultats sont illustrés sur la figure 3. Ce test consiste à introduire des contraintes à l'interface entre le revêtement et le substrat, ce qui est réalisé en appuyant un stylet de diamant sur la surface de l'échantillon avec une charge normale. L'échantillon est ensuite déplacé à vitesse constante et le résultat des contraintes à l'interface produit une éraflure ou un écaillement du revêtement. On enregistre et on appelle charge critique Lc, la plus petite charge entraînant un défaut sur l'échantillon.

La figure 3 représente donc en ordonnée la charge critique et en abscisse les résultats obtenus pour respectivement un échantillon de référence, un échantillon ayant subi uniquement l'étape de traitement par un plasma généré à partir d'un gaz oxydant, le résultat obtenu avec un échantillon ayant uniquement reçu le dépôt d'une couche d'un composé de carbone polymérique (à partir de $CH_4$) et enfin le résultat obtenu avec un échantillon selon l'invention, c'est-à-dire ayant reçu un prétraitement consistant en une étape de traitement de la surface comprenant la gravure par l'action d'un plasma généré par un gaz oxydant, suivie d'une étape de dépôt d'un composé de carbone polymérique (à partir de $CH_4$).

RESULTATS DES TESTS:

Sans prétraitement, les couches de $SiO_2$ sur polycarbonate s'écaillent à partir d'une épaisseur de 2 μm. Par contre, en utilisant le prétraitement selon le procédé de l'invention, non seulement elles ne s'écaillent plus, mais supportent aussi le traitement par cycle thermique sans écaillage et montrent une bonne résistance à l'eau. En particulier :
Une couche anti-rayure de 4.5 μm de SiO2 est déposée sur du polycarbonate.
Substrat : Une plaque de PC (10x10x0.3 cm) faite par extrusion ou injection

Tableau 1 :

| Condition de dépôt pour les différentes couches | | | | | |
|---|---|---|---|---|---|
| | gaz | flux [sccm] | pression [mTorr] | Puissance MO [W] | temps [s] |
| nettoyage $O_2$ | $O_2$ | 30 | 1.14 | 100 | 100 |
| Couche a-C:H 1 | $CH_4$ | 21 | 0.78 | 100 | 30 |
| Couche a-C:H 2 | $C_2H_4$ | 30 | 1.07 | 100 | 5 |
| Couche $SiO_2$ | $SiH_4$ $O_2$ | 5 24 | 1.14 | 100 | 10000 |
| Gradient phase 1: | $O_2$ $CH_4$ | $30{\rightarrow}0^{*)}$ $0{\rightarrow}21^{*)}$ | | 100 | 20 |
| Gradient phase 2 | $O_2$ $CH_4$ $SiH_4$ | $0{\rightarrow}24^{*)}$ $21{\rightarrow}0^{*)}$ $0{\rightarrow}5^{*)}$ | | 100 | 20 |

*) variation linéaire en 20 secondes

- test de quadrillage

| | Nombre de carrés restants |
|---|---|
| Traitement $O_2$ seul | écaillage |
| Traitement $CH_4$ seul | 30% |
| Traitement $O_2$+$CH_4$ | 100% |
| Traitement $O_2$+$C_2H_4$ | 100% |
| Traitement $O_2$+ Gradient phase 1+ Gradient phase 2**) | 100% |

**) Le plasma n'est pas arrêté pendant l'enchaînement des traitements

- Résistance à l'usure en fonction de l'épaisseur des couches

| | 3.5 μm | 5.5 μm |
|---|---|---|
| Changement de trouble (Delta Haze) après 1000 tours (galet CS F10-500g) | 14.6% | 2.06 % |

Ces tests montrent donc qu'un traitement selon l'invention permet d'obtenir une adhésion meilleure que lorsque le dépôt d'alliage de silicium est effectué sans prétraitement ou avec un prétraitement incomplet.

**Revendications**

1. Procédé de traitement de surface pour protection et fonctionnalisation des polymères (4) par dépôt par plasma (19) gazeux dans une enceinte confinée (16) d'au moins une couche (43) d'un composé de silicium, **caractérisé en ce que** le composé de silicium est choisi parmi le silicium, les oxydes de silicium, les nitrures de silicium, les oxynitrures de silicium et **en ce qu'**un pré-traitement de surface par plasma est effectué dans la même enceinte avant dépôt du composé de silicium, le pré-traitement consistant en un traitement de la surface comprenant la gravure d'une zone superficielle du polymère et en une étape de dépôt (42) d'un composé de carbone polymérique amorphe fortement hydrogéné avec au moins 10% d'hydrogène en pourcentage atomique.

2. Procédé selon la revendication 1, **caractérisé en ce qu'**on effectue d'abord le traitement de la surface puis, ensuite le dépôt du composé de carbone polymérique.

3. Procédé selon la revendication 1, **caractérisé en ce que** l'étape de dépôt du composé de carbone polymérique est commencée avant la fin du traitement de surface, ledit traitement de surface comprenant la gravure d'une zone superficielle du polymère.

4. Procédé selon l'une des revendications 1 à 3, **caractérisé en ce que** le traitement est obtenu par l'action d'un plasma (19) généré à partir d'un gaz oxydant.

5. Procédé selon la revendication 1 à 4, **caractérisé en ce que** l'épaisseur gravée de la zone superficielle est comprise entre 20 angströms et 3000 angströms.

6. Procédé selon l'une quelconque des revendications précédentes, **caractérisé en ce que** l'épaisseur gravée de la zone superficielle est comprise entre 100 angströms et 900 angströms et est préférentiellement approximativement de 500 angströms.

7. Procédé selon l'une quelconque des revendications précédentes, **caractérisé en ce que** le dépôt (42) du composé de carbone polymérique est obtenu par l'action d'un plasma (19) généré à partir d'un gaz carboné, les gaz carbonés étant choisis parmi le méthane, éthane, butane, propane, pentane, hexane et leurs dérivés mono ou poly insaturés dont l'éthylène, l'acétylène.

8. Procédé selon l'une quelconque des revendications précédentes, **caractérisé en ce que** l'épaisseur du dépôt (42) du composé de carbone est comprise entre 30 angströms et 130 angströms et préférentiellement entre 50 angströms et 100 angströms.

9. Procédé selon l'une quelconque des revendications précédentes, **caractérisé en ce que** le polymère est du polycarbonate.

10. Procédé selon l'une quelconque des revendications 1 à 8, **caractérisé en ce que** le polymère est une matière plastique choisie parmi les polyméthyle méthacrylates, les polyéthylènes, les polypropylènes, les polyéthylène téréphtalates.

11. Procédé selon l'une quelconque des revendications précédentes, **caractérisé en ce que** le polymère (4) brut est traité directement dans l'enceinte.

**12.** Procédé selon l'une quelconque des revendications précédentes, **caractérisé en ce que** plusieurs couches de composés de silicium sont déposées.

**13.** Procédé selon l'une quelconque des revendications précédentes, **caractérisé en ce que** le réacteur à plasma est un réacteur à résonance cyclotronique électronique distribuée.

**14.** Procédé selon l'une quelconque des revendications 1 à 10, **caractérisé en ce que** le réacteur à plasma est choisi parmi les réacteurs à micro-ondes ou radiofréquence dont les réacteurs à pulvérisation cathodique.

**Patentansprüche**

**1.** Verfahren zur Oberflächenbehandlung zum Schutz und zur Funktionalisierung der Polymere (4) durch Abscheidung wenigstens einer Schicht (43) aus einer Siliciumverbindung aus Gasplasma (19) in einer abgesperrten Kammer (16), **dadurch gekennzeichnet, dass** die Siliciumverbindung aus Silicium, Siliciumoxiden, Siliciumnitriden und Siliciumoxidnitriden ausgewählt wird und dass vor der Abscheidung der Siliciumverbindung in derselben Kammer eine Oberflächenvorbehandlung mit Plasma durchgeführt wird, wobei die Vorbehandlung aus einer Behandlung der Oberfläche, die das Ätzen einer Oberflächenzone des Polymers umfasst, und aus einem Schritt der Abscheidung (42) einer stark hydrierten amorphen polymeren Kohlenstoffverbindung mit wenigstens 10 Atomprozent Wasserstoff besteht.

**2.** Verfahren gemäß Anspruch 1, **dadurch gekennzeichnet, dass** zuerst die Oberflächenbehandlung und dann die Abscheidung der polymeren Kohlenstoffverbindung durchgeführt wird.

**3.** Verfahren gemäß Anspruch 1, **dadurch gekennzeichnet, dass** vor dem Ende der Oberflächenbehandlung mit dem Schritt der Abscheidung der polymeren Kohlenstoffverbindung begonnen wird, wobei die Oberflächenbehandlung das Ätzen einer Oberflächenzone des Polymers umfasst.

**4.** Verfahren gemäß einem der Ansprüche 1 bis 3, **dadurch gekennzeichnet, dass** die Behandlung durch Einwirkung eines Plasmas (19) erreicht wird, das aus einem oxidierenden Gas erzeugt wird.

**5.** Verfahren gemäß Anspruch 1 bis 4, **dadurch gekennzeichnet, dass** die Ätzdicke der Oberflächenzone zwischen 20 Angström und 3000 Angström liegt.

**6.** Verfahren gemäß einem der vorstehenden Ansprüche, **dadurch gekennzeichnet, dass** die Ätzdicke der Oberflächenzone zwischen 100 Angström und 900 Angström liegt und vorzugsweise ungefähr 500 Angström beträgt.

**7.** Verfahren gemäß einem der vorstehenden Ansprüche, **dadurch gekennzeichnet, dass** die Abscheidung (42) der polymeren Kohlenstoffverbindung durch Einwirkung eines Plasmas (19) erreicht wird, das aus einem kohlenstoffhaltigen Gas erzeugt wird, wobei das kohlenstoffhaltige Gas aus Methan, Ethan, Butan, Propan, Pentan, Hexan und ihren einfach oder mehrfach ungesättigten Derivaten, wie Ethylen, Acetylen, ausgewählt ist.

**8.** Verfahren gemäß einem der vorstehenden Ansprüche, **dadurch gekennzeichnet, dass** die Abscheidungsdicke (42) der Kohlenstoffverbindung zwischen 30 Angström und 130 Angström und vorzugsweise zwischen 50 Angström und 100 Angström liegt.

**9.** Verfahren gemäß einem der vorstehenden Ansprüche, **dadurch gekennzeichnet, dass** es sich bei dem Polymer um Polycarbonat handelt.

**10.** Verfahren gemäß einem der Ansprüche 1 bis 8, **dadurch gekennzeichnet, dass** es sich bei dem Polymer um einen Kunststoff handelt, der aus Polymethylmethacrylaten, Polyethylenen, Polypropylenen und Polyethylenterephthalaten ausgewählt ist.

**11.** Verfahren gemäß einem der vorstehenden Ansprüche, **dadurch gekennzeichnet, dass** das rohe Polymer (4) direkt in der Kammer behandelt wird.

**12.** Verfahren gemäß einem der vorstehenden Ansprüche, **dadurch gekennzeichnet, dass** mehrere Schichten aus Siliciumverbindungen abgeschieden werden.

**13.** Verfahren gemäß einem der vorstehenden Ansprüche, **dadurch gekennzeichnet, dass** der Plasmareaktor ein Reaktor mit verteilter elektronischer cyclotronischer Resonanz ist.

**14.** Verfahren gemäß einem der Ansprüche 1 bis 10, **dadurch gekennzeichnet, dass** der Plasmareaktor aus Mikrowellen- oder Hochfrequenzreaktoren, wie Kathodenzerstäubungsreaktoren, ausgewählt ist.

**Claims**

**1.** Method for treating a surface for protection and functionalization of polymers (4) by gas plasma (19) deposit in a confined chamber (16) of at least one layer (43) of a silicon alloy,
characterized in that the silicon alloy is selected from silicon and its oxides, nitrides and oxynitrides and **in that** a pre-treatment of the surface by plasma is performed in the same chamber before the silicon alloy is deposited, the pre-treatment consisting of a surface treatment comprising etching a surface zone of the polymer and a step which consists of depositing a polymeric amorphous carbon compound (42) highly hydrogenated with at least 10 % hydrogen by atomic percentage.

**2.** Method according to claim 1, **characterized in that** the surface treatment is performed first, followed by the deposit of the polymeric carbon compound.

**3.** Method according to claim 1, **characterized in that** the step of depositing the polymeric carbon compound is begun before the end of the surface treatment, said surface treatment comprising etching the surface zone of the polymer.

**4.** Method according to one of claims 1 to 3, **characterized in that** the treatment is obtained by the action of a plasma (19) generated from an oxidizing gas.

**5.** Method according to claims 1 to 4, **characterized in that** the etched thickness of the surface zone is between 20 angstroms and 3000 angstroms.

**6.** Method according to any one of the preceding claims, **characterized in that** the etched thickness of the surface zone is between 100 angstroms and 900 angstroms, and preferably approximately 500 angstroms.

**7.** Method according to any one of the preceding claims, **characterized in that** the deposit (42) of the polymeric carbon compound is obtained by the action of a plasma (19) generated from a carbon-containing gas, the carbon-containing gases being selected from methane, ethane, butane, propane, pentane, hexane and their mono or polyunsaturated derivatives including ethylene and acetylene.

**8.** Method according to any one of the preceding claims, **characterized in that** the thickness of the deposit (42) of the carbon compound is between 30 angstroms and 130 angstroms and preferably between 50 angstroms and 100 angstroms.

**9.** Method according to any one of the preceding claims, **characterized in that** the polymer is polycarbonate.

**10.** Method according to any one of claims 1 to 8, **characterized in that** the polymer is a plastic material selected from the polymethyl methacrylates, the polyethylenes, the polypropylenes, the polyethylene terephthalates.

**11.** Method according to any one of the preceding claims, **characterized in that** the raw polymer (4) is treated directly in the chamber.

**12.** Method according to any one of the preceding claims, **characterized in that** several layers of silicon alloys are deposited.

**13.** Method according to any one of the preceding claims, **characterized in that** the plasma reactor is a distributed electron cyclotron resonance reactor.

**14.** Method according to any one of claims 1 to 10, **characterized in that** the plasma reactor is selected from the microwave or radiofrequency reactors including the cathode sputtering reactors.

FIG.1

FIG.2

FIG. 3